# EUROPEAN PATENT SPECIFICATION

(11) **EP 3 723 219 B1**
(45) Date of publication and mention of the grant of the patent: **01.07.2026**
(21) Application number: 18886582.8
(22) Date of filing: 29.08.2018
(51) Int. Cl.: H02H 3/04, H02H 1/00, H03M 1/10, H03M 1/12

(54) **DIGITAL PROTECTION CONTROL DEVICE**
VORRICHTUNG ZUR STEUERUNG VON DIGITALEM SCHUTZ
DISPOSITIF DE CONTRÔLE DE PROTECTION NUMÉRIQUE

(30) Priority: 07.12.2017 JP 2017235354
(43) Date of publication of application: 14.10.2020
(73) Proprietor: Kabushiki Kaisha Toshiba, Tokyo 105-0023 (JP); Toshiba Energy Systems & Solutions Corporation, Kawasaki-shi, Kanagawa 212-0013 (JP)
(72) Inventor: ITAGAKI, Daiju, Kawasaki-shi Kanagawa 212-0013 (JP); KAWASAKI, Tomoyuki, Kawasaki-shi Kanagawa 212-0013 (JP); IIDA, Shingo, Kawasaki-shi Kanagawa 212-0013 (JP); SHIRAKAWA, Hiroyuki, Kawasaki-shi Kanagawa 212-0013 (JP); SHONO, Takaya, Kawasaki-shi Kanagawa 212-0013 (JP)
(74) Representative: Henkel & Partner mbB
(86) International application number: PCT/JP2018/031907
(87) International publication number: WO 2019/111454

(56) References cited:
- JP-A- 2001 028 829
- JP-A- 2001 258 146
- JP-A- 2003 199 240
- JP-A- 2004 289 975
- JP-A- H03 270 630
- JP-A- H1 094 157
- JP-A- S5 325 347
- US-A- 4 689 570
- US-A1- 2013 106 632
- US-B1- 9 698 809
- ANONYMOUS: "6-Channel DAS with 16-Bit, Bipolar Input, Dual Simultaneous Sampling ADC Data Sheet AD7616 Rev. 0 Document Feedback", 27 October 2016 (2016-10-27), XP055864256, Retrieved from the Internet <URL:https://www.analog.com/media/en/technical-documentation/data-sheets/AD7616.pdf> [retrieved on 20211122]

## Description

### [Technical Field]

Embodiments of the present invention relate to a digital protection control device.

### [Background Art]

In a plant of a power system that manages a state quantity which is available every moment such as an amount of electric energy, a control system including a plurality of digital protection control devices is widely operated. A digital protection control device acquires variation states of a plurality of facility devices that configure a plant and abnormal states such as problems that have occurred in the plurality of facility devices and performs stabilization control and system protection control.

In relation to the protection control system described above, a monitoring control device that controls a digital relay protecting a power system and performs control of a connection configuration and the like of the power system by detecting a problem (system problem) that has occurred in each of facility devices (a power transmission line, a transformer, and the like) of the power system and separating problem occurrence parts from the power system is used. Such facility devices, for example, receive analog state quantities of currents and voltages of the power system as inputs and perform various digital calculation processes on the basis of digital values into which the analog state quantities are converted through analog/digital conversion (hereinafter referred to as A/D conversion). As a system that receives analog signal quantities as inputs and performs various calculations, various devices such as a fault point evaluating device (a fault locator) that evaluates the position of a problem point on a power transmission line with a high accuracy, a system analyzing device (an oscilloscope device) that performs disturbance recording at the time of occurrence of a problem or the like, and a measurement device relating to power quality such as harmonics and an instantaneous drop are installed in addition to those described above. Here, an instantaneous drop is a phenomenon of a voltage instantaneously dropping due to lightning striking a power transmission line and the like.

In recent years, there also have been systems in which an A/D converter and a part performing a protection control calculation process are divided among separate devices when installed. The configuration of the A/D converter and a monitoring method in such protection control systems will be described here. As an example of a conventional configuration of an A/D converter, there is a method of sequentially inputting signals of a plurality of analog signal channels to one A/D converter using a multiplexer and performing A/D conversion.

As a method of monitoring deterioration of A/D conversion accuracy, there is a method in which a known reference DC voltage is input to an A/D converter, and a result of the conversion is checked. In addition, as a method for monitoring deterioration of characteristics of an analog filter, there is a method in which a harmonic signal is applied to the analog filter, and a result of the A/D conversion thereof is checked.

Conventionally, in order to monitor A/D conversion accuracy, for example, a known reference DC voltage is input to an A/D converter in a state in which an analog signal is separated, and it is checked whether or not a conversion value is correct. However, in this system, an analog signal is interrupted in accordance with conversion of an input, and thus, by using an A/D conversion system of a type in which a result having high accuracy is acquired by continuously sampling an analog signal at a high speed or oversampling an analog signal, there is a possibility of a correct result of A/D conversion being unable to be acquired. The reason for this is that, in a case in which an input of the A/D converter is switched to a reference DC voltage side, a time longer than a period of high-speed sampling is required for the conversion, and a part of sampling of an analog signal is missing. The oversampling described here is a technique for acquiring more input digital values than the number of output digital values and generating one output digital value from a plurality of input digital values.

Patent Literature 2 discloses systems and methods for identifying and reporting failures of an analog to digital (A/D) conversion system. An A/D conversion system includes a test signal generator configured to generate a test signal including an identifiable characteristic, an A/D converter configured to convert an analog signal measured at an input of the A/D converter to a digital output, and signal injection circuitry configured to inject at least a portion of the test signal from the test signal generator as an injected signal into the analog signal using trace-to-trace crosstalk. A method includes determining whether the digital output generated by the A/D converter indicates the identifiable characteristic.

### [Citation List]

### [Patent Literature]

[Patent Literature 1] Japanese Unexamined Patent Application, First Publication No. H04-038114.
[Patent Literature 2] US 9 698 809 B1

### [Non Patent Literature]

[Non-Patent Literature 1] Electric Technology Research Association, Volume no. 50, Issue 1, Second-generation digital relay, Chapter 4-4-1.

### [Summary of Invention]

### [Technical Problem]

The present invention concerns a digital protection control device according to independent claim 1.

An object to be achieved by the present invention is tc provide a digital protection control device capable of monitoring a characteristic abnormality while maintaining continuity of sampling of an analog signal.

### [Solution to Problem]

According to the present invention, there is provided a digital protection control device as set out in independent claim 1. Advantageous developments are defined in the dependent claims.

### [Brief Description of Drawings]

Fig. 1 is a diagram illustrating the configuration of a digital protection control device according to a first embodiment;
Fig. 2 is a flowchart illustrating the configuration of the digital protection control device according to the first embodiment;
Fig. 3 is a diagram illustrating an example in which switching of an A/D converter among components of a digital protection control device according to the first embodiment is performed;
Fig. 4 is a diagram illustrating an example in which a single analog filter among components of a digital protection control device according to a second embodiment is included;
Fig. 5 is a diagram illustrating an example in which a plurality of analog filters among components of the digital protection control device according to the second embodiment are included;
Fig. 6 is a diagram illustrating the configuration of a digital protection control device according to a third embodiment;
Fig. 7 is a diagram illustrating the configuration of the digital protection control device according to the third embodiment;
Fig. 8 is a diagram illustrating transitions of each signal in a case in which a monitoring result is normal according to the third embodiment;
Fig. 9 is a diagram illustrating transitions of each signal in a case in which a monitoring result is abnormal according to the third embodiment;
Fig. 10 is a diagram illustrating the configuration of a digital protection control device according to a fourth embodiment;
Fig. 11 is a diagram illustrating transitions of each signal in a case in which a monitoring result is normal according to the fourth embodiment;
Fig. 12 is a diagram illustrating transitions of each signal in a case in which a monitoring result is abnormal according to the fourth embodiment;
Fig. 13 is a diagram illustrating the configuration of a digital protection control device according to a fifth embodiment;
Fig. 14 is a diagram illustrating the configuration of a digital protection control device according to a sixth embodiment; and
Fig. 15 is a diagram illustrating the configuration of a digital protection control device according to a seventh embodiment.

### [Description of Embodiments]

Hereinafter, digital protection control devices according to embodiments will be described with reference to the drawing.

### (First embodiment)

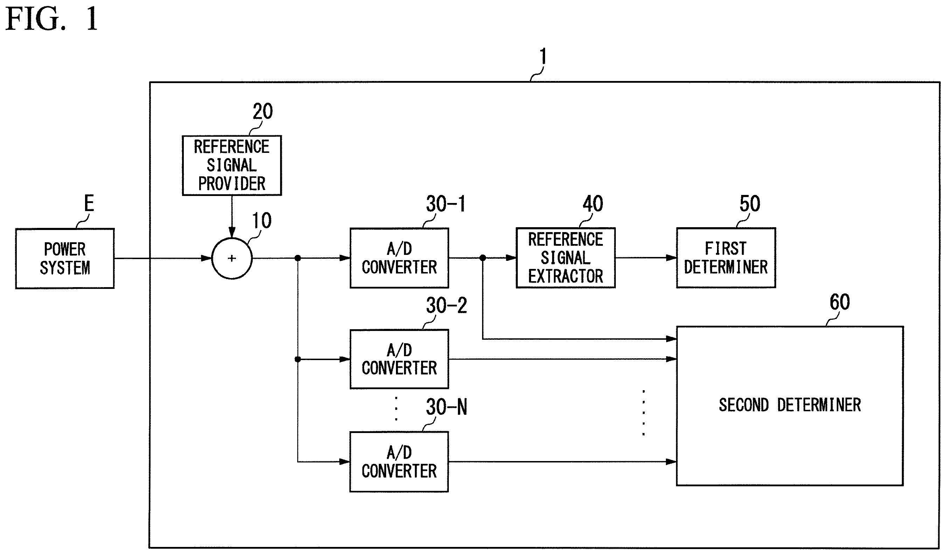

Hereinafter, a first embodiment will be described. Fig. 1 is a diagram illustrating the configuration of a digital protection control device 1 according to a first embodiment. As illustrated in Fig. 1, the digital protection control device 1 is connected to a power system E. The digital protection control device 1, for example, includes an adder 10, a reference signal provider 20, a plurality of A/D converters 30-1, 30-2, ..., 30-N (hereinafter, N is a natural number), a reference signal extractor 40, a first determiner 50, and a second determiner 60. Hereinafter, when a specific A/D converter does not need to be identified, it will be simply referred to as an A/D converter 30. In Fig. 1, only components relating to monitoring are extracted, and a configuration in which various processes are performed using an output of the A/D converter 30 is not illustrated. Hereinafter, this similarly applies to each embodiment.

An analog signal is input to the adder 10 from a power system E. Here, for example, the analog signal is a measured value of a voltage, a current, electric power, or the like in the power system E. In addition, a reference signal is input to the adder 10 from the reference signal provider 20. The adder 10 adds the analog signal and the reference signal and outputs a superimposed signal to the A/D converter 30. The A/D converter 30 converts the input superimposed signal into a digital value.

Hereinafter, the A/D converter 30 connected to the reference signal extractor 40 will be referred to as a connected A/D converter. In the example illustrated in Fig. 1, the A/D converter 30-1 corresponds to the connected A/D converter. The connected A/D converter outputs a digital value to the reference signal extractor 40. The reference signal extractor 40 extracts a component of a reference signal from a digital value input from the connected A/D converter and outputs a result of the extraction to the first determiner 50. For example, in a case in which the reference signal is a DC signal, the reference signal extractor 40 can extract a value represented by the reference signal by acquiring an average for a predetermined period. Instrument transformers (PT and CT) disposed between the power system E and the digital protection control device 1 have a characteristic of not allowing a DC component of an input from the power system E to be transmitted. For this reason, in a case in which the reference signal is a DC signal, the reference signal extractor 40 can extract a value represented by the reference signal without being influenced by an input from the power system E.

By comparing an extraction result input from the reference signal extractor 40 with a value represented by a known reference signal, the first determiner 50 performs monitoring of accuracy of at least the connected A/D converter. In a case in which the extraction result input from the reference signal extractor 40 and the value represented by the known reference signal coincide with each other, the first determiner 50 determines that the connected A/D converter and signal pass circuits (1) are normal. Here, the signal pass circuits (1) represents a circuit part which is connected to the connected A/D converter and through which a signal after the reference signal is superimposed thereon by the reference signal provider 20 passes. "Coinciding" means falling within a predetermined range having a value represented by the known reference signal as its center. In a case in which the input extraction result does not coincide with the value represented by the known reference signal, the first determiner 50 determines that there is an abnormality in the connected A/D converter or the signal pass circuits (1).

The second determiner 60 compares digital values output by the A/D converters 30-1 to 30-N with each other and determines whether or not there is a non-coincidence value. In a case in which there is a non-coincidence value, the second determiner 60 determines that there is an abnormality in the A/D converter 30 that has output the non-coincidence value or signal pass circuits (2). The signal pass circuits (2) described here represents a circuit part which is connected to a target A/D converter 30 and through which a signal after superimposition of a reference signal performed by the reference signal provider 20 passes. Since the reference signal is superimposed on a signal input to the A/D converter 30, even in a case in which there is no input of an analog signal from the power system E, the second determiner 60 can determine an abnormality of the A/D converter 30.

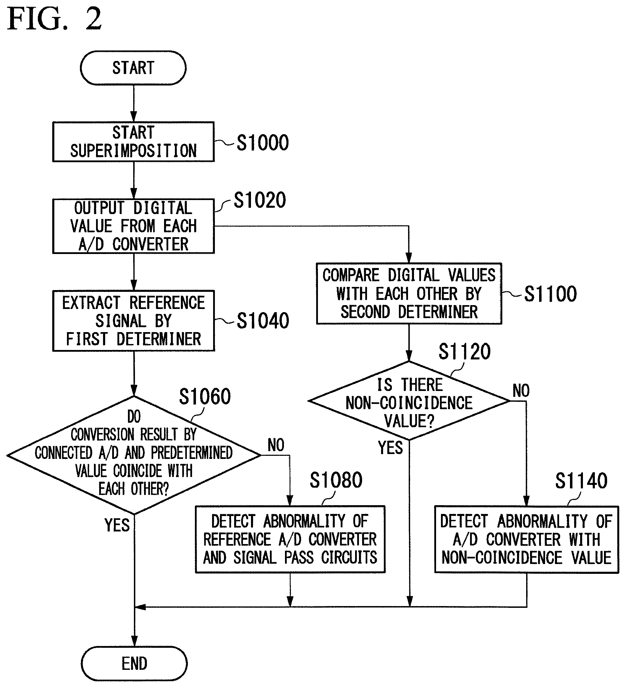

Fig. 2 is a flowchart illustrating one example of the flow of a process executed by the digital protection control device according to the first embodiment.

First, the reference signal provider 20 outputs a reference signal to the adder 10 and starts superimposition of the signal (Step S1000). Next, each A/D converter 30 converts the input superimposed signal into a digital value and outputs the converted digital value (Step S1020).

The first determiner 50 acquires a value represented by the reference signal extracted by the reference signal extractor 40 from the digital value output by the connected A/D converter (Step S1040). The first determiner 50 determines whether or not the extraction result coincides with the predetermined value (Step S1060) and detects an abnormality of the connected A/D converter that has output the reference signal or the signal pass circuits (1) in a case in which no coincidence is determined (Step S1080). The signal pass circuits (1) is the circuit part described above which is connected to the connected A/D converter and through which a signal after superimposition of the reference signal performed by the reference signal provider 20 passes. In a case in which an abnormality of at least one of the connected A/D converter and the signal pass circuits (1) is detected, the first determiner 50 notifies a monitoring device of the digital protection control device 1 of the detected abnormality.

On the other hand, the second determiner 60 compares digital values output by the A/D converters 30 with each other (Step S1100). The second determiner 60 determines whether or not there is a non-coincidence value in the digital values that have been compared with each other (Step S1120) and detects an abnormality of the A/D converter 30 that has output the non-coincidence value or the signal pass circuits (2) in a case in which there is a non-coincidence value (Step S1140). In a case in which an abnormality of one of the A/D converter 30 or the signal pass circuits (2) is detected, the second determiner 60 notifies a monitoring device of the digital protection control device 1 of the detected abnormality. In this way, the process of this flowchart ends.

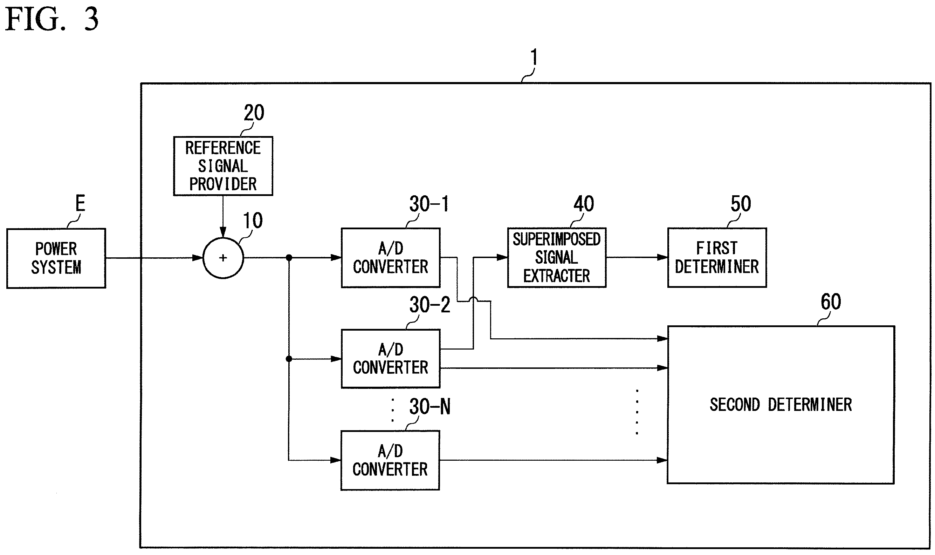

A connected A/D converter connected to the reference signal extractor 40 may not be fixed, and a connected A/D converter may be configured to be arbitrarily selectable from among a plurality of A/D converters 30. Fig. 3 is a diagram illustrating a view in which an A/D converter connected to the reference signal provider 20 is switched from the A/D converter 30-1 to the A/D converter 30-2 in the digital protection control device 1 according to the first embodiment. The switching is realized by operating a changeover switch manually or on the basis of a signal from a control device not illustrated in the drawing. However, during the monitoring process illustrated in Fig. 2, the switching of a connected A/D converter is assumed not to be performed.

By employing such a configuration, the digital protection control device 1 can determine whether or not an abnormality has occurred at least in the connected A/D converter, and by comparing digital values output by the plurality of A/D converters 30 with each other, can determine whether or not an abnormality has occurred in at least one of the A/D converters 30 and the signal pass circuits (2). When such a determination is performed, the function of each of the A/D converters 30 does not need to be stopped, and thus monitoring can be performed without missing sampling of an analog signal from the power system E.

According to the digital protection control device 1 of the first embodiment described above, by including the first determiner 50 that determines whether or not an abnormality has occurred in at least one of the connected A/D converter and the signal pass circuits (1) by comparing an extraction result input from the reference signal extractor 40 with a value represented by a known reference signal and the second determiner that compares digital values output from the plurality of A/D converters 30 with each other, and in a case in which there is a non-coincidence value, determines that there is an abnormality in at least one of the A/D converter 30 that has output the non-coincidence value and the signal pass circuits (2), monitoring of a characteristic abnormality can be performed without interrupting sampling of an analog signal.

### (Second embodiment)

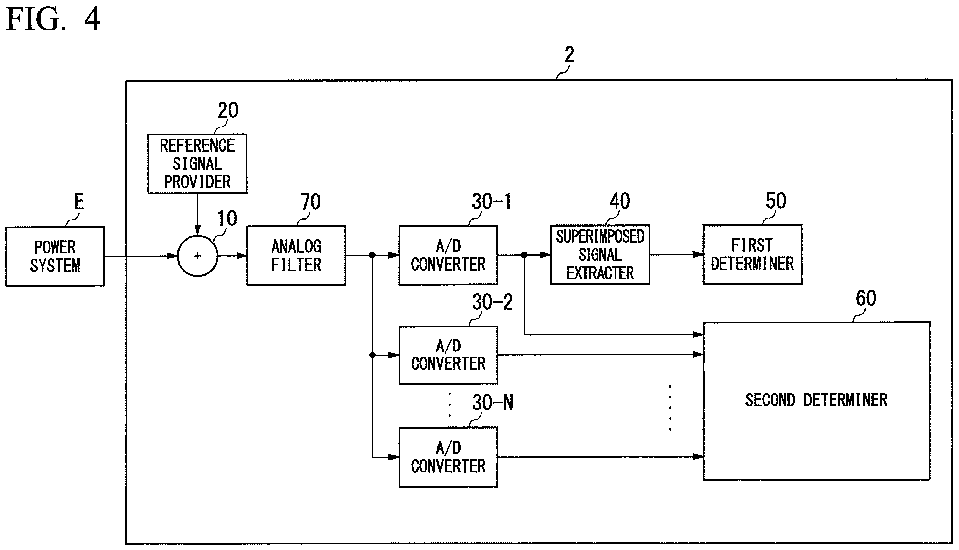

Hereinafter, a second embodiment will be described. Fig. 4 is a configuration diagram of a digital protection control device 2 according to the second embodiment. The digital protection control device 2 has a configuration acquired by adding an analog filter to the digital protection control device 1 according to the first embodiment. As illustrated in Fig. 4, in the digital protection control device 2 connected to a power system E, compared to the first embodiment, an analog filter 70 is disposed between an adder 10 and A/D converters 30.

Points different from the first embodiment will be focused on in the following description, and description of points common to the first embodiment will be omitted.

The analog filter 70 is disposed between the adder 10 and the A/D converters 30. The analog filter 70 allows components of frequency bands, which are included in the superimposed signal, that are appropriate for monitoring the state of the power system to pass through it and cuts off other components.

A first determiner 50 performs determination similar to that according to the first embodiment for a conversion result acquired by a connected A/D converter which has passed through the analog filter 70. In accordance with this, the first determiner 50 can monitor characteristic abnormalities of the connected A/D converter and/or signal pass circuits (1) including the analog filter 70.

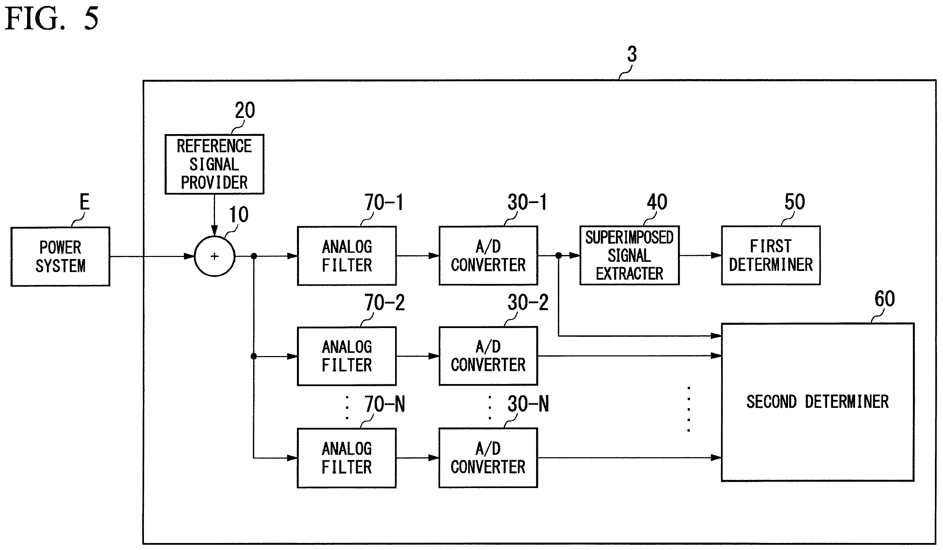

Fig. 5 is a configuration diagram of a digital protection control device 2A according to another aspect of the second embodiment. As illustrated in Fig. 5, in the digital protection control device 2A connected to a power system E, a plurality of analog filters 70-1 to 70-N are disposed in correspondence with a plurality of A/D converters 30-1 to 30-N.

Although the configuration including the single analog filter 70 illustrated in Fig. 4 can minimize the circuit scale, there is a possibility of sufficient monitoring being unable to be performed in a case in which the analog filter 70 deteriorates. On the other hand, according to the configuration including the plurality of analog filters 70-1 to 70-N illustrated in Fig. 5, in a case in which the characteristics of the analog filters 70-1 to 70-N rapidly deteriorate, characteristic abnormalities can be found more quickly.

By employing such configurations, the digital protection control devices 2 and 2A can simultaneously perform monitoring without missing sampling of an analog signal from the power system E while determining whether an abnormality has occurred in at least one of the A/D converters 30 and signal pass circuits (1) which is connected to the A/D converter 30 and through which a signal after a reference signal has been superimposed thereon by the reference signal provider 20 passes in a state in which a frequency band is narrowed down to a frequency band that is appropriate for monitoring the power system E.

According to the digital protection control devices 2 and 2A of the second embodiment described above, similar to the first embodiment, characteristic abnormalities can be monitored without interrupting sampling of an analog signal.

### (Third example)

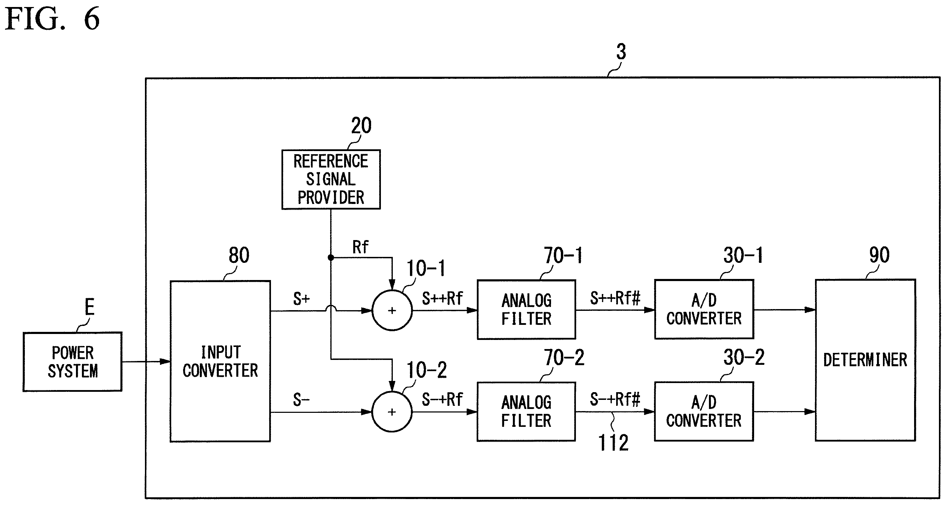

Hereinafter, a third example outside the scope of the invention will be described. Fig. 6 is a configuration diagram of a digital protection control device 3 according to the third example. As illustrated in Fig. 6, the digital protection control device 3 connected to a power system E, for example, includes adders 10-1 and 10-2, a reference signal provider 20, A/D converters 30-1 and 30-2, analog filters 70-1 and 70-2, an input converter 80, and a determiner 90. Hereinafter, when a specific analog filter does not need to be identified, it will be simply referred to as an analog filter 70. In this configuration, the analog filters 70 may be omitted.

An analog signal is input to the input converter 80 from the power system E. The input converter 80 outputs a positive-side differential output (S+) (an example of a first differential signal) and a negative-side differential output (S-) (an example of a second differential signal) as differential signals. The positive-side differential output (S+) is input from the input converter 80 to the adder 10-1. The negative-side differential output (S-) is input from the input converter 80 to the adder 10-2. In addition, a reference signal (Rf) is input from the reference signal provider 20 to each of the adders 10-1 and 10-2. The adder 10-1 adds the positive-side differential output (S+) and the reference signal (Rf) and outputs a positive-side superimposed signal (S++Rf). The adder 10-2 adds the negative-side differential output (S-) and the reference signal (Rf) and outputs a negative-side superimposed signal (S-+Rf). The positive-side superimposed signal (S++Rf) is input to the analog filter 70-1. The negative-side superimposed signal (S-+Rf) is input to the analog filter 70-2.

The analog filter 70-1 converts the positive-side superimposed signal (S++Rf) into a positive-side superimposed/filtered signal (S++Rf#) of a frequency band that is appropriate for monitoring and outputs the positive-side superimposed/filtered signal (S++Rf#). The analog filter 70-2 converts the negative-side superimposed signal (S-+Rf) into a negative-side superimposed/filtered signal (S-+Rf#) of a frequency band that is appropriate for monitoring and outputs the negative-side superimposed/filtered signal (S-+Rf#). The A/D converter 30-1 converts the input positive-side superimposed/filtered signal (S++Rf#) into a digital value and outputs the digital value to the determiner 90. The A/D converter 30-2 converts the input negative-side superimposed/filtered signal (S-+Rf#) into a digital value and outputs the digital value to the determiner 90. The determiner 90 extracts components of a reference signal by performing a predetermined calculation for an input digital value. The determiner 90 performs monitoring of A/D conversion accuracy on the basis of a result of the predetermined calculation. In a case in which an abnormality is detected, the determiner 90 notifies a monitoring device of the digital protection control device, which is not illustrated in the drawing, of the detection of the abnormality.

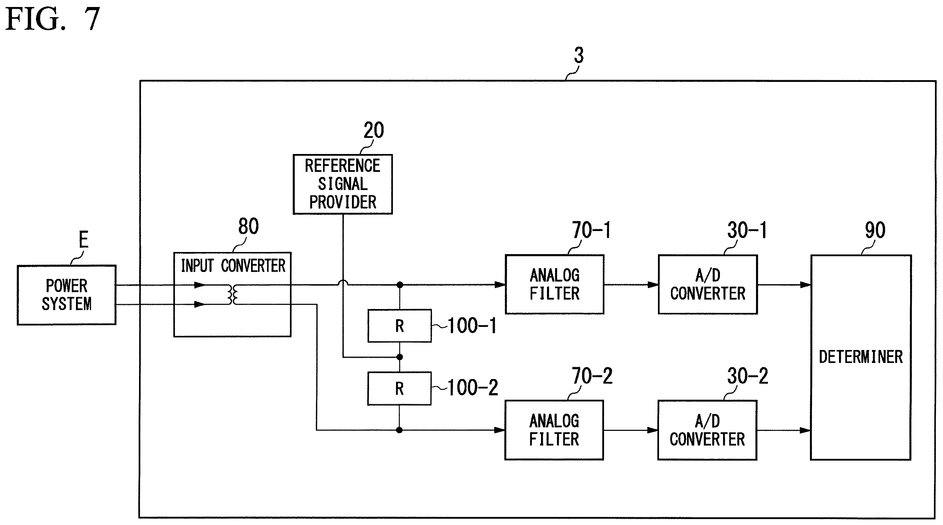

Fig. 7 is a diagram more specifically illustrating a configuration relating to the input converter 80 of the digital protection control device 3. The input converter 80, for example, includes a differential transformer such as a transformer. The differential transformer that is the input converter 80 converts an analog signal from the power system E into a differential signal and outputs the acquired differential signal. Resistance units 100-1 and 100-2 are included between the reference signal provider 20 and the analog filter 70. Hereinafter, when a specific resistance unit does not need to be identified, it will be simply referred to as a resistance unit 100.

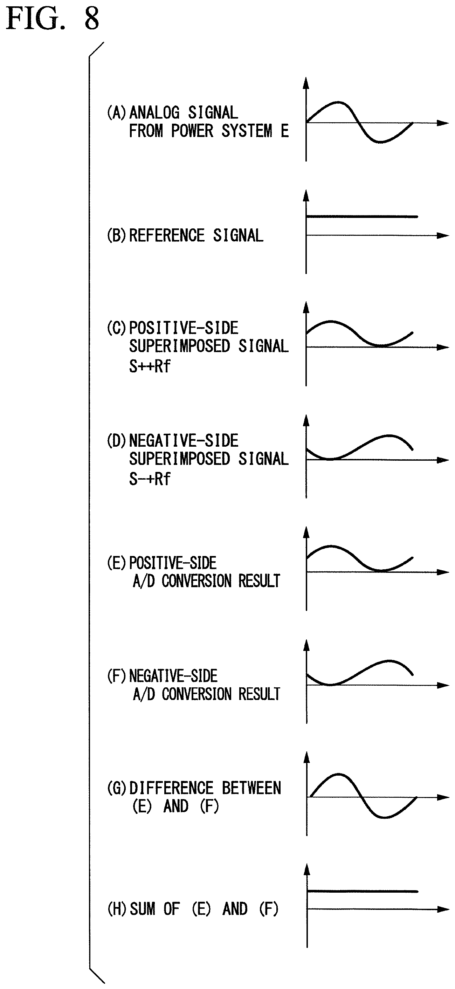

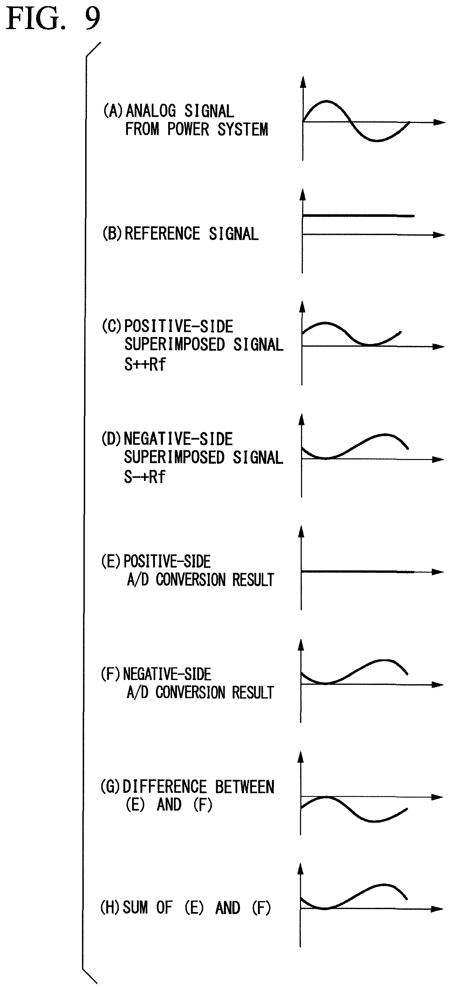

Figs. 8 and 9 are diagrams illustrating a calculation method for monitoring according to the third example. Fig. 8 is a diagram illustrating transitions of each signal in a case in which a characteristic abnormality has not occurred in the A/D converter 30.

The analog signal is an AC as illustrated in Fig. 8(A), and the reference signal is a DC as illustrated in Fig. 8(B). The positive-side superimposed signal (S++Rf) is acquired by adding the analog signal and the reference signal as illustrated in Fig. 8(C), and the negative-side superimposed signal (S-+Rf) is acquired by adding an opposite-polarity analog signal and the reference signal as illustrated in Fig. 8(D). As illustrated in Fig. 8(E), a positive-side A/D conversion result is acquired by converting the positive-side superimposed signal (S++Rf) into a digital value (it is represented using a curve in the drawing but is actually a sequence of points for every sampling period). As illustrated in Fig. 8(F), a negative-side A/D conversion result is acquired by converting the negative-side superimposed signal (S-+Rf) into a digital value (similar to Fig. 8(E), it is actually a sequence of points for every sampling period).

The determiner 90 can acquire an analog signal conversion result in which a component of the reference signal is cancelled by acquiring a difference (Fig. 8(G)) between the positive-side A/D conversion result (Fig. 8(E)) and the negative-side A/D conversion result (Fig. 8(F)). This signal can be used for sampling an analog signal which is its original purpose. The determiner 90 acquires a determination signal in which the component of the analog signal is cancelled by acquiring a sum (Fig. 8(H)) of the positive-side A/D conversion result (Fig. 8(E)) and the negative-side A/D conversion result (Fig. 8(F)) (an example of the predetermined calculation). In the example illustrated in Fig. 8, the determination signal coincides with a value represented by the reference signal, and thus it is determined that the A/D converter 30 and signal pass circuits are normal. Here, the signal pass circuits represents a circuit part which is connected to the A/D converter 30 and through which a signal after superimposition of the reference signal performed by the reference signal provider 20 passes and, for example, is the analog filter 70.

Fig. 9 is a diagram illustrating transitions of each signal in a case in which a characteristic abnormality has occurred in the A/D converter 30. In the example illustrated in Fig. 9, a sum (Fig. 9(H)) of a positive-side A/D conversion result (Fig. 9(E)) and a negative-side A/D conversion result (Fig. 9(F)) does not coincide with a reference signal (Fig. 9(B)), and thus it is determined that at least one of the A/D converters 30 and signal pass circuits is abnormal.

By employing such a configuration, the digital protection control device 3 can simultaneously perform monitoring without missing sampling of an analog signal from the power system E while determining whether or not an abnormality has occurred in at least one of the A/D converters 30 and the signal pass circuitss by acquiring a difference between digital values of A/D conversion results output by two A/D converters 30 to which differential signals converted from an analog signal from the power system E are input and determining whether the difference coincides with a known reference signal.

A case in which gains of the A/D converter 30-1 and the A/D converter 30-2 are different from each other may be considered as well. Hereinafter, the gain of the A/D converter 30-1 will be denoted by G-1, and the gain of the A/D converter 30-2 will be denoted by G-2. By acquiring a sum of a value acquired by multiplying the positive-side A/D conversion result (Fig. 9(E)) by the gain G-2 and a value acquired by multiplying the negative-side A/D conversion result (Fig. 9(F)) by the gain G-1 (another example of the predetermined calculation), the determiner 90 acquires a determination signal in which components of the analog signal are cancelled.

In this way, the digital protection control device 4 can perform different gain adjustment for each of the A/D converter 30-1 and the A/D converter 30-2. In this case, the digital protection control device 4 can broaden a dynamic range that the digital protection control device 4 can support, for example, by causing the A/D converter 30-1 to support a small signal range and causing the other A/D converter 30-2 to support a large signal range.

According to the digital protection control device 3 of the third example described above, by performing a predetermined calculation for some or all of digital values acquired by converting an analog signal from a power system E into differential signals and inputting the differential signals to two A/D converters 30 using the input converter 80, a characteristic abnormality can be monitored without interrupting sampling of the analog signal.

### (Fourth example)

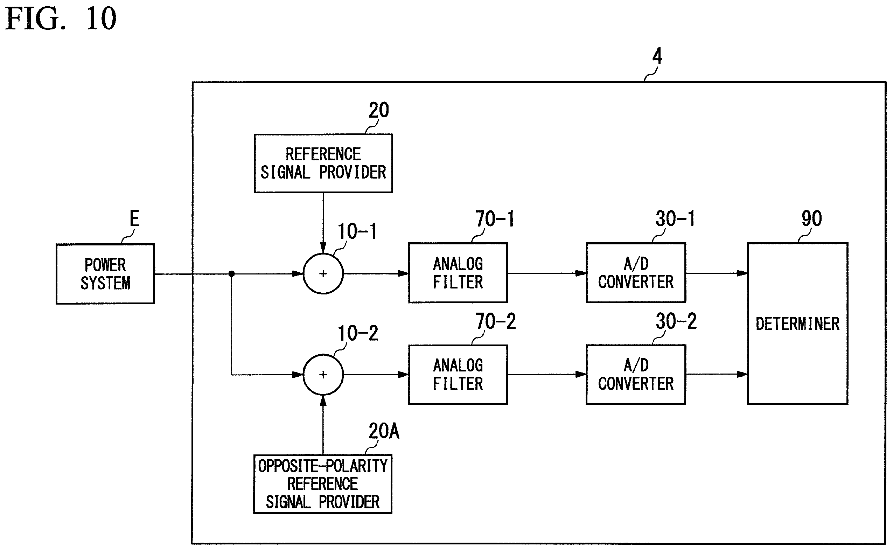

Hereinafter, a fourth example outside the scope of the invention will be described. As illustrated in Fig. 10, as a digital protection control device 4 according to the fourth example, the digital protection control device 4 connected to a power system E, for example, includes adders 10-1 and 10-2, a reference signal provider 20, an opposite-polarity reference signal provider 20A, A/D converters 30-1 and 30-2, analog filters 70-1 and 70-2, and a determiner 90. In this configuration, the analog filter 70 may be omitted.

An analog signal is input from the power system E to the adders 10-1 and 10-2. In addition, a reference signal is input to the adder 10-1 from the reference signal provider 20, and an opposite-polarity reference signal is input to the adder 10-2 from the opposite-polarity reference signal provider 20A. A superimposed signal acquired by adding the analog signal and the reference signal is input to the analog filter 70-1 from the adder 10-1. An opposite-polarity superimposed signal acquired by adding the analog signal and the opposite-polarity reference signal is input to the analog filter 70-2 from the adder 10-2. An opposite-polarity superimposed/filtered signal acquired by converting the superimposed signal into a frequency band that is appropriate for monitoring is input to the A/D converter 30-1 from the analog filter 70-1. A superimposed/filtered signal acquired by converting the opposite-polarity superimposed signal into a frequency band that is appropriate for monitoring is input to the A/D converter 30-2 from the analog filter 70-2. A digital value acquired by converting the superimposed/filtered signal is input to the determiner 90 from the A/D converter 30-1, and a digital value acquired by converting the opposite-polarity superimposed/filtered signal is input to the determiner 90 from the A/D converter 30-2. The determiner 90 extracts a reference signal by performing a predetermined calculation for the digital value and monitors A/D conversion accuracy. In a case in which an abnormality is detected, the determiner 90 notifies a monitoring device of the digital protection control device not illustrated in the drawing of the detection of the abnormality.

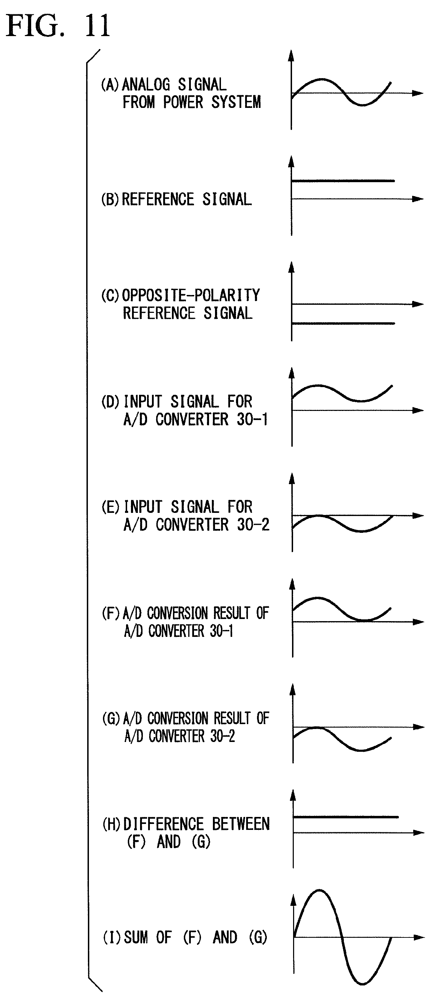

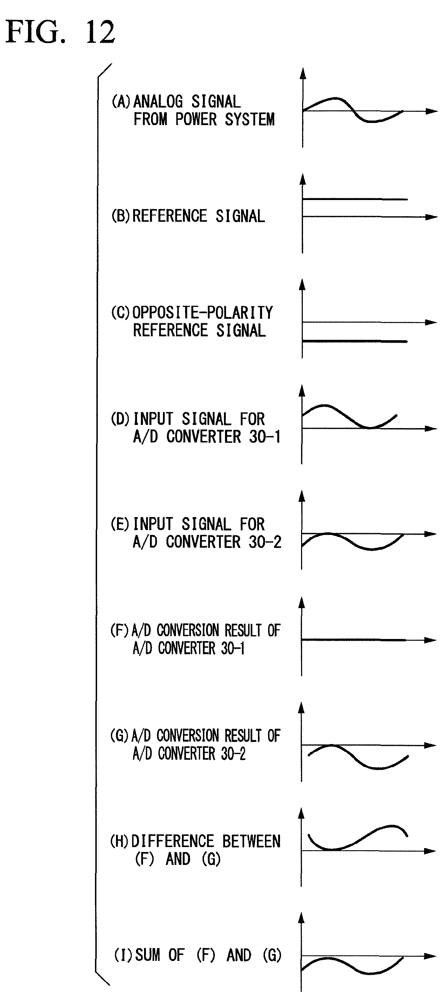

Figs. 11 and 12 are diagrams illustrating a calculation method for monitoring according to the fourth example. Fig. 11 is a diagram illustrating transitions of each signal in a case in which a characteristic abnormality has not occurred in the A/D converters 30-1 and 30-2.

As illustrated in Fig. 11(A), the analog signal is an AC, and as illustrated in Figs. 8(B) and 8(C), the reference signal is a DC. As illustrated in Fig. 11(D), an A/D conversion result of the A/D converter 30-1 is acquired by adding the analog signal and the reference signal, and as illustrated in Fig. 8(E), an A/D conversion result of the A/D converter 30-2 is acquired by adding the analog signal and the opposite-polarity reference signal. As illustrated in Fig. 8(F), an A/D conversion result of the A/D converter 30-1 is acquired by converting a superimposed signal into a digital value (it is represented using a curve in the drawing but is actually a sequence of points for every sampling period). As illustrated in Fig. 8(G), an A/D conversion result of the A/D converter 30-2 is acquired by converting an opposite-polarity superimposed signal into a digital value (similar to Fig. 8(F), it is actually a sequence of points for every sampling period).

The determiner 90 acquires a determination signal in which components of an input signal from the power system E are cancelled by acquiring a difference (Fig. 11(H)) between the A/D conversion result (Fig. 11(E)) of the A/D converter 30-1 and the A/D conversion result (Fig. 11(F)) of the A/D converter 30-2. In the example illustrated in Fig. 11, the determination signal coincides with a value represented by the reference signal, and thus it is determined that the A/D converter 30 and signal pass circuits are normal. The determiner 90 can acquire an analog signal conversion result in which a component of the reference signal and a component of the opposite-polarity reference signal are cancelled by acquiring a sum (Fig. 11(I)) of the A/D conversion result (Fig. 11(F)) of the A/D converter 30-1 and the A/D conversion result (Fig. 11(G)) of the A/D converter 30-2. This analog signal conversion result can be acquired as a waveform of which amplitude is twice that of the input signal (Fig. 11(A)), which is the original purpose.

Fig. 12 is a diagram illustrating transitions of each signal in a case in which a characteristic abnormality has occurred in the A/D converter 30. In the example illustrated in Fig. 12, a difference (Fig. 12(H)) between an A/D conversion result (Fig. 12(F)) of the A/D converter 30-1 and an A/D conversion result (Fig. 12(G)) of the A/D converter 30-2 does not coincide with a reference signal (Fig. 12(B)), and thus it is determined that at least the A/D converter 30 or signal pass circuits is abnormal.

By employing such a configuration, an analog signal from the power system E is input to two A/D converters 30, a reference signal is superimposed in one A/D converter 30, an opposite-polarity reference signal is superimposed in the other A/D converter 30, and then a predetermined calculation is performed for two A/D conversion results, whereby a characteristic abnormality can be monitored using whether or not only a component of the reference signal can be extracted as a determination criterion.

According to the digital protection control device 4 of the fourth example described above, by performing a predetermined calculation for some or all of a digital value of an A/D conversion result of the first A/D converter 30 in which the reference signal is superimposed and a digital value of an A/D conversion result of the second A/D converter 30 in which the opposite-polarity reference signal is superimposed, a characteristic abnormality can be monitored without interrupting sampling of an analog signal.

When the reference signal superimposed in the first to second embodiments and third to fourth examples is configured as a harmonic signal having a frequency higher than that of the analog signal from the power system E, a signal of a harmonic band including the reference signal is cut off by the analog filter 70. The determiner 90 can easily find deterioration of the analog filter 70 by extracting a harmonic component of an input signal, for example, using a fast Fourier transform (FFT) process and determining whether or not the harmonic component sufficiently attenuates.

When the reference signal superimposed in the first to second embodiments and third to fourth examples is configured as a signal that is composed of both a DC and a harmonic signal of a frequency higher than that of an analog signal from the power system E, by measuring the input signal for a predetermined period, the reference signal can be monitored with high sensitivity without being influenced by an input from the power system E, and deterioration of the analog filter can be easily found.

In a case in which a harmonic signal is used as the reference signal superimposed in the first to second embodiments and third to fourth examples, the frequency is set to a frequency that is 51 times the frequency of the power system E or more. In many cases, harmonics measurement for noise cutting of a general power system is for harmonics of a frequency up to 50 times the frequency of an input wave as its measurement target. The reference signal is accurately measured without being influenced by noise originating from the power system E by configuring the frequency to be higher than 51 times the frequency of the power system E or more. By using a high-frequency signal of a frequency equal to or higher than 51 times the frequency of the power system E as a reference signal, an analog signal of the power system E is accurately measured and is output to other components without being influenced in accordance with voltage variations of the high-frequency signal that is the reference signal.

By configuring the reference signal superimposed in the first to second embodiments and third to fourth examples to be a signal composed of a DC signal of which the value (voltage) changes in a time series, even in a case in which a DC offset of the A/D converter 30 is large, the gain of A/D conversion can be monitored with high sensitivity without being influenced by the DC offset. At the same time, according to this configuration, an effect of increasing a detection probability of a defect of a mode such that it becomes an accuracy abnormality in a specific input range can be expected as well.

In a case in which the reference signal superimposed in the first to second embodiments and third to fourth examples is configured to be a low-frequency signal (not a DC) of a frequency lower than the frequency of the power system E, high-sensitivity monitoring can be performed without being influenced by an input from the power system E, and even in a case in which a DC offset of the A/D converter 30 becomes larger, the gain of the A/D conversion can be monitored with high sensitivity without being influenced by the DC offset. The low-frequency signal is not limited to an AC signal and may be a triangular wave or the like. For example, a case may be assumed in which an instrument transformer (a PT or a CT) through which it is difficult for a low-frequency signal to pass is mounted on an upstream side of a reference signal provider inside a digital protection control device. Thus, an analog signal is input to the digital protection control device in a state in which a low-frequency component is cut off. For this reason, by configuring a low-frequency signal to be a reference signal, only the reference signal can be extracted with high sensitivity by the A/D converter 30, and as a result, high-sensitivity monitoring can be performed.

### (Fifth example)

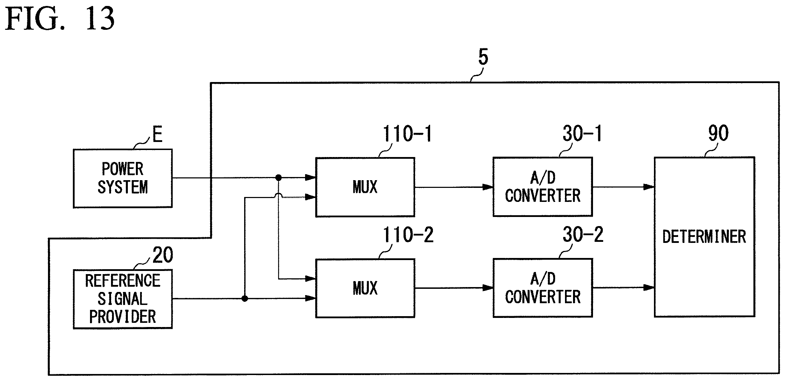

Hereinafter, a fifth example outside the scope of the invention will be described. Fig. 13 is a configuration diagram of a digital protection control device 5 according to the fifth example. As illustrated in Fig. 13, the digital protection control device 5 connected to a power system E, for example, includes a reference signal provider 20, A/D converters 30-1 and 30-2, a determiner 90, and multiplexers 110-1 and 110-2. Hereinafter, when a specific multiplexer does not need to be identified, it will be simply referred to as a multiplexer 110.

An analog signal is input to the multiplexer 110 from the power system E. In addition, a reference signal is input to the multiplexer 110 from the reference signal provider 20. From the multiplexer 110, one of the analog signal and the reference signal is selectively input to the A/D converter 30, or both the analog signal and the reference signal are input to the A/D converter 30. It is preferable to perform manual switching or control such that the analog signal is input to at least one or more A/D converters 30. In such a case, even when a certain A/D converter 30 receives the reference signal as an input, the sampling of the analog signal can be configured not to be interrupted.

Digital values that are A/D conversion results are input to the determiner 90 from the A/D converters 30. The determiner 90 controls multiplexers 110 and recognizes the states thereof. The determiner 90 recognizes whether a signal input from the A/D converter 30 is based on the analog signal or is based on the reference signal and thus outputs a signal based on the analog signal to another component as the original A/D conversion result. The determiner 90 monitors the soundness of the A/D conversion circuit on the basis of whether a signal based on the reference signal is in a predetermined range. In a case in which a predetermined calculation result is not in the predetermined range, the determiner 90 detects an abnormality and notifies a monitoring device of the digital protection control device which is not illustrated in the drawing.

The determiner 90 can connect the analog signal to all the A/D converters 30. The determiner 90 compares analog signal conversion results of the A/D converters 30 with each other and, in a case in which there is a difference between two A/D conversion results (in a case in which there is a non-coincidence value), can detect in an early stage that there is a defect in at least one of the A/D converters 30.

By employing such a configuration, an abnormality of the A/D converters 30 can be monitored while the sampling of an analog signal is continued by selectively performing switching between the analog signal from the power system E and the reference signal and outputting the selected signal to the plurality of the A/D converters 30 by using the multiplexer 110.

According to the digital protection control device 5 of the fifth example described above, by selectively inputting analog signals of the same channel from the power system E and the reference signal to the A/D converter 30, a characteristic abnormality of the A/D converter 30 can be monitored while the analog signal is continuously sampled.

### (Sixth example)

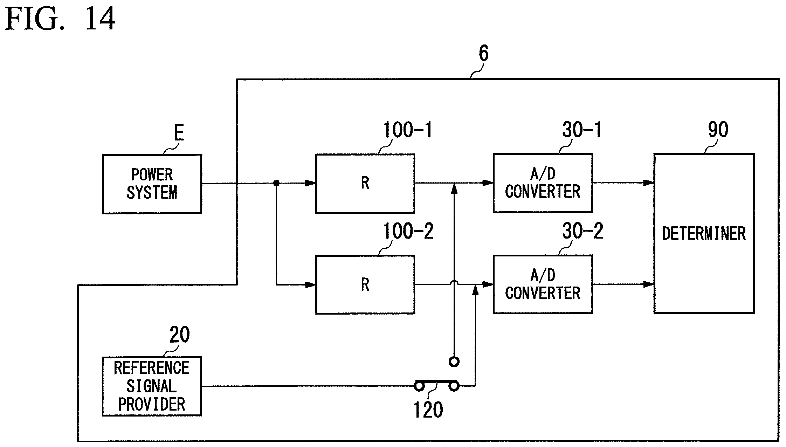

Fig. 14 is a configuration diagram of a digital protection control device 6 according to a sixth example outside the scope of the invention. As illustrated in Fig. 14, the digital protection control device 6 connected to a power system E, for example, includes a reference signal provider 20, A/D converters 30-1 and 30-2, a determiner 90, resistance units 100-1 and 100-2, and a changeover switching unit 120. The changeover switching unit 120 is one example of "input switching unit".

An analog signal is input to the resistance unit 100-1 from the power system E. An analog signal is input to the resistance unit 100-2 from the power system E. An analog signal of which a gain is adjusted is input from the resistance unit 100-1 to the A/D converter 30-1. An analog signal of which a gain is adjusted is input from the resistance unit 100-2 to the A/D converter 30-2. A reference signal is input from the reference signal provider 20 to one of the A/D converters 30-1 and 30-2. The determiner 90 controls one of the A/D converters 30-1 and 30-2 to which the reference signal is to be input using the changeover switching unit 120. By configuring output impedance of the reference signal provider 20 side to be lower than that of the A/D converter 30, the reference signal is input to the A/D converter 30 without receiving the influence of the analog signal from the power system E.

Digital values of A/D conversion results are input to the determiner 90 by the A/D converters 30-1 and 30-2. The determiner 90 recognizes states thereof by controlling the changeover switching unit 120. The determiner 90 recognizes whether a signal input from the A/D converter 30 is based on the analog signal or is based on a signal acquired by superimposing the reference signal on the analog signal and thus, outputs the signal based on the analog signal to another component as the original A/D conversion result. The determiner 90 extracts a component of the reference signal by acquiring a difference between an A/D conversion result of the signal based on the analog signal and an A/D conversion result of the signal based on the signal acquired by superimposing the reference signal on the analog signal. The determiner 90 monitors the soundness of the A/D conversion circuit on the basis of whether or not an extraction result is in a predetermined range. In a case in which a predetermined calculation result is not in a predetermined range, the determiner 90 detects an abnormality and notifies a monitoring device of the digital protection control device which is not illustrated in the drawing.

By employing such a configuration, an abnormality of the A/D converters 30 can be monitored while sampling of an analog signal is continued by inputting the analog signal from the power system E using a plurality of the A/D converters 30 and selectively outputting the reference signal to one A/D converter 30 using the changeover switching unit 120.

According to the digital protection control device 6 of the sixth example described above, by performing a predetermined calculation for an A/D conversion result of the A/D converter 30 connected to both the analog signal from the power system E and the reference signal and an A/D conversion result of the A/D converter 30 connected to the analog signal from the power system E, the reference signal is input using a least one or more A/D converters 30 among a plurality of A/D converters 30 while the analog signal is continuously sampled, whereby a characteristic abnormality can be monitored.

### (Seventh example)

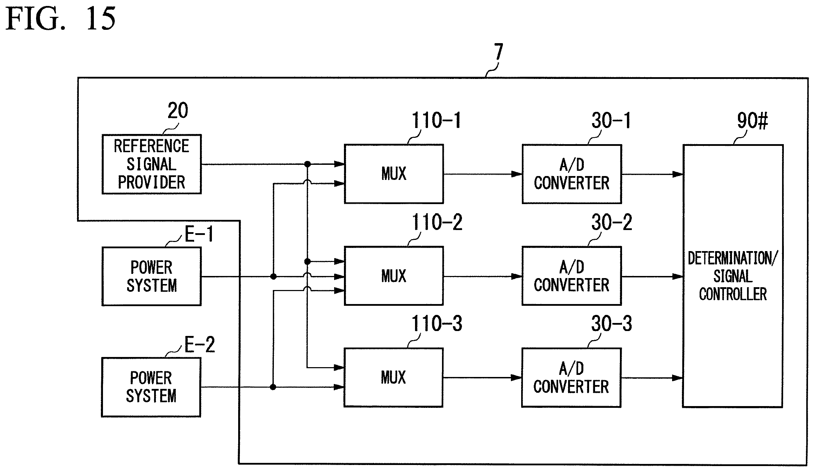

Hereinafter, a seventh example outside the scope of the invention will be described. Fig. 15 is a configuration diagram of a digital protection control device 7 according to a seventh example. As illustrated in Fig. 15, the digital protection control device 7 connected to power systems E-1 and E-2, for example, includes a reference signal provider 20, A/D converters 30-1, 30-2, and 30-3, a determination/signal controller 90#, and multiplexers 110-1, 110-2, and 110-3. Hereinafter, points different from the fifth example will be focused on in description, and description of points common to the fifth example will be omitted.

An analog signal S1 from the power system E-1, an analog signal S2 from the power system E-2, and a reference signal from the reference signal provider 20 are input to the multiplexer 110. One of the analog signal S1, the analog signal S2, and the reference signal is selectively input to the A/D converter 30 from the multiplexer 110.

For example, in the digital protection control device 7, the sampling of a reference signal using the A/D converter 30-1, the sampling of an analog signal S1 using the A/D converter 30-2, and the sampling of an analog signal S2 using the A/D converter 30-3 are started, and, after a predetermined time elapses, switching is performed such that the analog signal S1 is input to the A/D converter 30-1, the reference signal is input to the A/D converter 30-2, and the analog signal S2 is input to the A/D converter 30-3, and the sampling is continued. After a predetermined time further elapses, the digital protection control device 7 performs switching such that the analog signal S1 is input to the A/D converter 30-1, the analog signal S2 is input to the A/D converter 30-2, and the reference signal is input to the A/D converter 30-3, and the sampling is continued. By switching the input channels in this way, the digital protection control device 7 can continue the sampling of the analog signals S1 and S2 while monitoring an A/D conversion accuracy of the A/D converter 30 using the reference signal. The determination/signal controller 90# recognizes whether a signal input from the A/D converter 30 is based on the analog signal or is based on the reference signal. The determination/signal controller 90# monitors soundness of the A/D conversion circuit on the basis of whether or not a determination result of a signal based on the reference signal is in a predetermined range. Different from the determiners 90 according to the first to second embodiments and third to fifth examples, the determination/signal controller 90# outputs a signal based on the analog signal to another component as an original A/D conversion result. Such a function may be implemented in the other embodiments and examples. In a case in which verification similar to that of the fifth example is performed, A/D converters 30 of which the number is twice the number of analog signal channels are required at least. On the other hand, in the seventh example, the number of A/D converters 30 may be at least (the number of analog signal channels + 1), and the required number of A/D converters 30 can be reduced. Although Fig. 15 illustrates an example in which two analog signals S1 and S2 are monitored and determined through three A/D converters 30, the configuration of this example is not limited thereto. For example, an application example in which three or more analog signals are monitored and determined through A/D converters 30 of an arbitrary number may be assumed.

By employing such a configuration, by performing sampling of analog signals from the power system E using a plurality of A/D converters 30, analog signal channels inside the digital protection system device can be continuously sampled while an abnormality of each A/D converter 30 is monitored using the reference signal.

According to the digital protection control device 7 of the seventh example described above, analog signals of the same channel from the power system E can be connected to a plurality of A/D converters 30, and, by disposing a device to which a different analog signal channel can be connected in each A/D converter 30, the number of A/D converters 30 in the entire device can be inhibited to be (the number of analog channels +1).

In A/D converters 30 used in the first to second embodiments and third to seventh examples, a plurality of A/D converters 30 that are disposed may use A/D converters having different conversion systems together. In the plurality of A/D converters 30 that are disposed, for example, at least one A/D converter 30 is composed of a sequential comparison-type A/D converter, and at least another A/D converter 30 is composed of a ΔΣ-type A/D converter. The ΔΣ-type A/D converter has resolution higher than that of the sequential comparison-type A/D converter and has a low A/D conversion speed. The ΔΣ-type A/D converter has low responsiveness and is not toward a process of performing frequently switching between input signals using the multiplexer 110 or the like. On the other hand, the sequential comparison-type A/D converter has resolution lower than that of the ΔΣ-type A/D converter, but has high responsiveness owing to a high conversion speed, and can respond also to a process of frequently performing switching between input signals using the multiplexer 110 or the like. For this reason, the A/D converter 30 inside the device uses both the sequential comparison-type A/D converter and the ΔΣ-type A/D converter, thereby realizing measurement monitoring utilizing advantages of each type. The ΔΣ-type A/D converter includes a feedback circuit inside thereof, and thus there are cases in which the ΔΣ-type A/D converter exhibits a transient unstable reaction to an input. For this reason, by comparing an output result of the ΔΣ-type A/D converter with an output result of the sequential comparison-type A/D converter, it can be monitored whether a reaction of the ΔΣ-type A/D converter becomes unstable.

In the A/D converter 30 used in the first to second embodiments and third to seventh examples, the monitoring of whether a plurality of ΔΣ-type A/D converters exhibit unstable reactions has the same result even when analog signals of the same channel are input under the condition of adjustment of the same gain, and thus, an abnormality cannot be found. On the other hand, in a plurality of A/D converters 30 that are disposed, under the condition of adjustment of different gains, when analog signals of the same channel are input, a ΔΣ-type A/D converter having a lower gain tends to become more stable than a ΔΣ-type A/D converter having a higher gain. For this reason, the determiner 90 can determine an abnormality in a case in which the A/D converter having the higher gain and the A/D converter having the lower gain exhibit different reactions.

In a case in which the digital protection control devices according to the first to second embodiments and third to seventh examples are connected to a plurality of analog signals formed of a channel having a small input signal and a channel having a large input signal, the A/D converter 30 having a larger gain is used in a case in which the analog signal is small, and the A/D converter 30 having a smaller gain is used in a case in which the analog signal is large, whereby A/D conversion having a high dynamic range can be performed.

In a plurality of A/D converters 30 used in the first to second embodiments and third to seventh examples, at least one A/D converter 30 may include an oversampling A/D converter. While the oversampling A/D converter does not need to continuously sample an input signal, the digital protection control devices according to the first to second embodiments and third to seventh examples can perform sampling without interrupting the input signal. As described above, in the digital protection control device according to the first to second embodiments and third to seventh examples the A/D converter 30 can monitor the reference signal. For this reason, in the digital protection control devices according to the first to second embodiments and third to seventh examples the oversampling A/D converter can be used.

According to at least one of the embodiments and examples described above, the digital protection control device includes a plurality of A/D converters 30 and, by inputting a reference signal to at least one of the A/D converters 30 with being superimposed on an analog signal, can monitor an abnormality of the digital protection control device with high sensitivity and can continuously perform sampling of an analog signal input from the power system E at the same time.

While several embodiments of the present invention have been described, such embodiments are presented as examples but are not intended to limit the scope of the present invention. These embodiments may be performed in other various forms, and various omissions, substitutions, and changes may be performed in a range not departing from the concept of the present invention therein. The scope of the present invention is therefore only limited by the appended claims.

## Claims

1. A digital protection control device (1, 2) comprising:
a plurality of analog/digital converters (30-1, ..., 30-N) configured to convert an analog signal from a power system (E) into digital values;
a reference signal provider (20) configured to superimpose a reference signal on the analog signal which is to be input into the plurality of analog/digital converters (30-1, ..., 30-N);
a reference signal extractor (40) configured to extract a component of the reference signal from a digital value which has been output from one connected analog/digital converter among the plurality of analog/digital converters (30-1, ..., 30-N), wherein the one connected analog/digital converter received input of the analog signal superimposed with the reference signal by the reference signal provider (20) ;
a first determiner (50) configured to determine, on the basis of the component of the reference signal extracted by the reference signal extractor (40), whether or not an abnormality has occurred in at least one of the one connected analog/digital converter and upstream-side circuits with reference to the one connected analog/digital converter,
wherein the first determiner (50) is configured to
acquire a value represented by the reference signal extracted by the reference signal extractor (40) from the digital value output by the one connected analog/digital converter,
determine whether or not the acquired value coincides with a predetermined value, and
detect an abnormality of at least one of the one connected analog/digital converter and the upstream-side circuits in a case in which no coincidence is determined; and
a second determiner (60) configured to determine whether or not an abnormality has occurred in at least part of the plurality of analog/digital converters (30-1, ..., 30-N) by comparing the digital values which have been output from the plurality of analog/digital converters (30-1, ..., 30-N) with each other,
wherein the second determiner (60) is configured to
determine whether or not there is a non-coincidence value in the digital values which have been compared with each other, and
detect an abnormality of the analog/digital converter that has output the non-coincidence value in a case in which there is the non-coincidence value.

2. The digital protection control device (2) according to claim 1, further comprising: an analog filter (70) between the plurality of analog/digital converters (30-1, ..., 30-N) and a node (10) at which the reference signal is input,
wherein the first determiner (50) is configured to determine whether or not an abnormality has occurred in at least one of the one connected analog/digital converter, the analog filter (70), and the upstream-side circuits of the connected analog/digital converters, and
wherein the second determiner (60) is configured to determine whether or not an abnormality has occurred in at least part of the plurality of analog/digital converters (30-1, ..., 30-N) by comparing the digital values which have been output from the plurality of analog/digital converters (30-1, ..., 30-N) with each other.

3. The digital protection control device (1, 2) according to any one of claims 1 and 2, wherein the reference signal is a DC signal.

4. The digital protection control device (1, 2) according to any one of claims 1 and 2, wherein the reference signal is a harmonic signal of a frequency higher than an analog AC electric quantity of the power system (E).

5. The digital protection control device (1, 2) according to any one of claims 1 and 2, wherein the reference signal is both a DC signal and a harmonic signal of a frequency higher than an analog AC electric quantity of the power system (E).

6. The digital protection control device (1, 2) according to claim 4 or 5, wherein the harmonic signal has a frequency that is equal to or higher than 51 times the analog signal of the power system (E).

7. The digital protection control device (1, 2) according to any one of claims 1 and 2, wherein the reference signal is a low-frequency signal of a frequency lower than an AC frequency of the power system (E).

8. The digital protection control device (1, 2) according to claim 7, wherein a frequency of the low-frequency signal is equal to or lower than 1 Hz.

9. The digital protection control device (1, 2) according to any one of claims 1 to 8, wherein the plurality of analog/digital converters (30-1, ..., 30-N) include at least two or more analog/digital converters of which conversion systems are different from each other.

10. The digital protection control device (1, 2) according to any one of claims 1 to 8, wherein the analog/digital converter includes at least one or more analog/digital converters of which output gains are different from each other for analog signals of the same channel.

11. The digital protection control device (1, 2) according to any one of claims 1 to 10, wherein the analog/digital converter includes at least one or more oversampling analog/digital converters.

## Patentansprüche

1. Digitale Schutzsteuervorrichtung (1, 2), umfassend:
eine Mehrzahl von Analog/Digital-Wandlern (30-1, ..., 30-N), die konfiguriert sind, um ein analoges Signal von einem Stromnetz (E) in digitale Werte umzuwandeln;
einen Referenzsignalgeber (20), der konfiguriert ist, um dem analogen Signal, das in die Mehrzahl von Analog/Digital-Wandlern (30-1, ..., 30-N) einzugeben ist, ein Referenzsignal zu überlagern;
einen Referenzsignalextraktor (40), der konfiguriert ist, um eine Komponente des Referenzsignals aus einem digitalen Wert zu extrahieren, der von einem angeschlossenen Analog/Digital-Wandler aus der Mehrzahl von Analog/Digital-Wandlern (30-1, ..., 30-N) ausgegeben wurde, wobei der eine angeschlossene Analog/Digital-Wandler eine Eingabe des analogen Signals empfing, dem das Referenzsignal durch den Referenzsignalgeber (20) überlagert ist;
einen ersten Bestimmer (50), der konfiguriert ist, um auf der Grundlage der durch den Referenzsignalextraktor (40) extrahierten Komponente des Referenzsignals zu bestimmen, ob eine Anomalie in mindestens einem von dem einen angeschlossenen Analog/Digital-Wandler und vorgeschalteten Schaltungen in Bezug auf den einen angeschlossenen Analog/Digital-Wandler aufgetreten ist oder nicht,
wobei der erste Bestimmer (50) konfiguriert ist, um
einen Wert zu erfassen, der durch das Referenzsignal repräsentiert wird, das von dem Referenzsignalextraktor (40) aus dem von dem einen angeschlossenen Analog/Digital-Wandler ausgegebenen digitalen Wert extrahiert wurde,
zu bestimmen, ob der erfasste Wert mit einem vorbestimmten Wert übereinstimmt oder nicht, und
eine Anomalie von mindestens einem von dem einen angeschlossenen Analog/Digital-Wandler und den vorgeschalteten Schaltungen in einem Fall zu detektieren, in dem keine Übereinstimmung bestimmt wird; und
einen zweiten Bestimmer (60), der konfiguriert ist, um zu bestimmen, ob eine Anomalie in mindestens einem Teil der Mehrzahl von Analog/Digital-Wandlern (30-1, ..., 30-N) aufgetreten ist oder nicht, indem die digitalen Werte, die von der Mehrzahl von Analog/Digital-Wandlern (30-1, ..., 30-N) ausgegeben wurden, miteinander verglichen werden,
wobei der zweite Bestimmer (60) konfiguriert ist, um
zu bestimmen, ob es einen Nicht-Übereinstimmungswert in den digitalen Werten gibt, die miteinander verglichen wurden, und
eine Anomalie des Analog/Digital-Wandlers zu detektieren, der den Nicht-Übereinstimmungswert ausgegeben hat, in einem Fall, in dem der Nicht-Übereinstimmungswert vorhanden ist.

2. Die digitale Schutzsteuervorrichtung (2) nach Anspruch 1, ferner umfassend: einen Analogfilter (70) zwischen der Mehrzahl von Analog/Digital-Wandlern (30-1, ..., 30-N) und einem Knoten (10), an dem das Referenzsignal eingegeben wird,
wobei der erste Bestimmer (50) konfiguriert ist, um zu bestimmen, ob eine Anomalie in mindestens einem von dem einen angeschlossenen Analog/Digital-Wandler, dem Analogfilter (70) und den vorgeschalteten Schaltungen der angeschlossenen Analog/Digital-Wandler aufgetreten ist oder nicht, und
wobei der zweite Bestimmer (60) konfiguriert ist, um zu bestimmen, ob eine Anomalie in mindestens einem Teil der Mehrzahl von Analog/Digital-Wandlern (30-1, ..., 30-N) aufgetreten ist oder nicht, indem die digitalen Werte, die von der Mehrzahl von Analog/Digital-Wandlern (30-1, ..., 30-N) ausgegeben wurden, miteinander verglichen werden.

3. Die digitale Schutzsteuervorrichtung (1, 2) nach einem der Ansprüche 1 und 2, wobei das Referenzsignal ein Gleichspannungssignal ist.

4. Die digitale Schutzsteuervorrichtung (1, 2) nach einem der Ansprüche 1 und 2, wobei das Referenzsignal ein harmonisches Signal mit einer Frequenz ist, die höher ist als eine analoge elektrische Wechselstromgröße des Stromnetzes (E).

5. Die digitale Schutzsteuervorrichtung (1, 2) nach einem der Ansprüche 1 und 2, wobei das Referenzsignal sowohl ein Gleichspannungssignal als auch ein harmonisches Signal mit einer Frequenz ist, die höher ist als eine analoge elektrische Wechselstromgröße des Stromnetzes (E).

6. Die digitale Schutzsteuervorrichtung (1, 2) nach Anspruch 4 oder 5, wobei das harmonische Signal eine Frequenz hat, die gleich oder höher als das 51-fache der Frequenz des analogen Signals des Stromnetzes (E) ist.

7. Die digitale Schutzsteuervorrichtung (1, 2) nach einem der Ansprüche 1 und 2, wobei das Referenzsignal ein niederfrequentes Signal mit einer Frequenz ist, die niedriger ist als eine Wechselstromfrequenz des Stromnetzes (E).

8. Die digitale Schutzsteuervorrichtung (1, 2) nach Anspruch 7, wobei eine Frequenz des niederfrequenten Signals gleich oder niedriger als 1 Hz ist.

9. Die digitale Schutzsteuervorrichtung (1, 2) nach einem der Ansprüche 1 bis 8, wobei die Mehrzahl von Analog/Digital-Wandlern (30-1, ..., 30-N) mindestens zwei oder mehr Analog/Digital-Wandler einschließt, deren Wandlungssysteme sich voneinander unterscheiden.

10. Die digitale Schutzsteuervorrichtung (1, 2) nach einem der Ansprüche 1 bis 8, wobei die Mehrzahl der Analog/DigitalWandler mindestens einen oder mehrere Analog/Digital-Wandler einschließt, deren Ausgangsverstärkungen sich für analoge Signale desselben Kanals voneinander unterscheiden.

11. Die digitale Schutzsteuervorrichtung (1, 2) nach einem der Ansprüche 1 bis 10, wobei die Mehrzahl der Analog/Digital-Wandler mindestens einen oder mehrere überabgetastete Analog/Digital-Wandler einschließt.

## Revendications

1. Dispositif de commande de protection numérique (1, 2) comprenant :
une pluralité de convertisseurs analogiques/numériques (30-1, ..., 30-N) configurés pour convertir un signal analogique provenant d'un réseau électrique (E) en valeurs numériques ;
un fournisseur de signal de référence (20) configuré pour superposer un signal de référence au signal analogique qui doit être entré dans la pluralité de convertisseurs analogiques/numériques (30-1, ..., 30-N) ;
un extracteur de signal de référence (40) configuré pour extraire une composante du signal de référence d'une valeur numérique qui a été sortie par un convertisseur analogique/numérique connecté parmi la pluralité de convertisseurs analogiques/numériques (30-1, ..., 30-N), dans lequel le un convertisseur analogique/numérique connecté a reçu en entrée le signal analogique superposé avec le signal de référence par le fournisseur de signal de référence (20) ;
un premier déterminateur (50) configuré pour déterminer, sur la base de la composante du signal de référence extraite par l'extracteur de signal de référence (40), si une anomalie s'est produite ou non dans au moins l'un du un convertisseur analogique/numérique connecté et des circuits en amont par rapport au un convertisseur analogique/numérique connecté,
dans lequel le premier déterminateur (50) est configuré pour
acquérir une valeur représentée par le signal de référence extraite par l'extracteur de signal de référence (40) de la valeur numérique sortie par le un convertisseur analogique/numérique connecté,
déterminer si la valeur acquise coïncide ou non avec une valeur prédéterminée, et
détecter une anomalie d'au moins l'un du un convertisseur analogique/numérique connecté et des circuits en amont dans un cas où aucune coïncidence n'est déterminée ; et
un second déterminateur (60) configuré pour déterminer si une anomalie s'est produite ou non dans au moins une partie de la pluralité de convertisseurs analogiques/numériques (30-1, ..., 30-N) en comparant les valeurs numériques qui ont été sorties par la pluralité de convertisseurs analogiques/numériques (30-1, ..., 30-N) les unes avec les autres,
dans lequel le second déterminateur (60) est configuré pour
déterminer s'il existe ou non une valeur de non-coïncidence dans les valeurs numériques qui ont été comparées les unes avec les autres, et
détecter une anomalie du convertisseur analogique/numérique qui a sorti la valeur de non-coïncidence dans un cas où il y a la valeur de non-coïncidence.

2. Le dispositif de commande de protection numérique (2) selon la revendication 1, comprenant en outre : un filtre analogique (70) entre la pluralité de convertisseurs analogiques/numériques (30-1, ..., 30-N) et un nœud (10) au niveau duquel le signal de référence est entré,
dans lequel le premier déterminateur (50) est configuré pour déterminer si une anomalie s'est produite ou non dans au moins l'un du un convertisseur analogique/numérique connecté, du filtre analogique (70) et des circuits en amont des convertisseurs analogiques/numériques connectés, et
dans lequel le second déterminateur (60) est configuré pour déterminer si une anomalie s'est produite ou non dans au moins une partie de la pluralité de convertisseurs analogiques/numériques (30-1, ..., 30-N) en comparant les valeurs numériques qui ont été sorties par la pluralité de convertisseurs analogiques/numériques (30-1, ..., 30-N) les unes avec les autres.

3. Le dispositif de commande de protection numérique (1, 2) selon l'une quelconque des revendications 1 et 2, dans lequel le signal de référence est un signal CC.

4. Le dispositif de commande de protection numérique (1, 2) selon l'une quelconque des revendications 1 et 2, dans lequel le signal de référence est un signal harmonique d'une fréquence supérieure à une grandeur électrique analogique CA du réseau électrique (E).

5. Le dispositif de commande de protection numérique (1, 2) selon l'une quelconque des revendications 1 et 2, dans lequel le signal de référence est à la fois un signal CC et un signal harmonique d'une fréquence supérieure à une grandeur électrique analogique CA du réseau électrique (E).

6. Le dispositif de commande de protection numérique (1, 2) selon la revendication 4 ou 5, dans lequel le signal harmonique a une fréquence qui est égale ou supérieure à 51 fois la fréquence du signal analogique du réseau électrique (E).

7. Le dispositif de commande de protection numérique (1, 2) selon l'une quelconque des revendications 1 et 2, dans lequel le signal de référence est un signal basse fréquence d'une fréquence inférieure à une fréquence CA du réseau électrique (E).

8. Le dispositif de commande de protection numérique (1, 2) selon la revendication 7, dans lequel une fréquence du signal basse fréquence est égale ou inférieure à 1 Hz.

9. Le dispositif de commande de protection numérique (1, 2) selon l'une quelconque des revendications 1 à 8, dans lequel la pluralité de convertisseurs analogiques/numériques (30-1, ..., 30-N) inclut au moins deux convertisseurs analogiques/numériques ou plus dont les systèmes de conversion sont différents les uns des autres.

10. Le dispositif de commande de protection numérique (1, 2) selon l'une quelconque des revendications 1 à 8, dans lequel la pluralité de convertisseurs analogiques/numériques inclut au moins un ou plusieurs convertisseurs analogiques/numériques dont les gains de sortie sont différents les uns des autres pour des signaux analogiques du même canal.

11. Le dispositif de commande de protection numérique (1, 2) selon l'une quelconque des revendications 1 à 10, dans lequel la pluralité de convertisseurs analogiques/numériques inclut au moins un ou plusieurs convertisseurs analogiques/numériques à suréchantillonnage.
